(19) **Europäisches Patentamt**
**European Patent Office**
**Office européen des brevets**

(11) **EP 2 817 734 B1**

(12) **EUROPEAN PATENT SPECIFICATION**

(45) Date of publication and mention
of the grant of the patent:
**23.05.2018 Bulletin 2018/21**

(51) Int Cl.:
*G06F 17/11* *(2006.01)*    *E21B 41/00* *(2006.01)*

(21) Application number: **13803695.9**

(86) International application number:
**PCT/US2013/042841**

(22) Date of filing: **28.05.2013**

(87) International publication number:
**WO 2013/188090 (19.12.2013 Gazette 2013/51)**

(54) **METHODS AND SYSTEMS FOR GAS LIFT RATE MANAGEMENT**

VERFAHREN UND SYSTEME ZUR GASFÖRDERUNGSRATENVERWALTUNG

PROCÉDÉS ET SYSTÈMES DE GESTION DE VITESSE D'EXTRACTION AU GAZ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.06.2012 US 201261660678 P**

(43) Date of publication of application:
**31.12.2014 Bulletin 2015/01**

(73) Proprietor: **Landmark Graphics Corporation
Houston, Texas 77042 (US)**

(72) Inventors:
• **FLEMING, Graham, Christopher
Houston, TX 77041 (US)**
• **LU, Qin
Houston, TX 77494 (US)**

(74) Representative: **Patel, Nikesh et al
A.A. Thornton & Co.
10 Old Bailey
London EC4M 7NG (GB)**

(56) References cited:
**US-A1- 2008 065 363    US-A1- 2011 119 037
US-A1- 2011 270 591    US-A1- 2012 059 640**

• **P WANG ET AL: "OPTIMIZATION OF
PRODUCTION FROM MATURE FIELDS",
STANFORD UNIVERSITY, 1 September 2002
(2002-09-01), XP055194471, 17th World
Petroleum Congress**
• **Walt Dobbs ET AL: "SPE 145070 Coupled
Surface/Subsurface Simulation of an Offshore K2
Field", SPE Reservoir Characterisation and
Simulation Conference, 11 October 2011
(2011-10-11), XP055194586, Retrieved from the
Internet:
URL:https://www.onepetro.org/download/conf
erence-paper/SPE-145070-MS?id=conference-p
aper/SPE-145070-MS [retrieved on 2015-06-09]**
• **Pengje Wang ET AL: "Gas Lift Optimization for
Long-Term Reservoir Simulations", SPE Annual
Technical Conference and Exhibition, 26-29
September, Houston, Texas, 29 September 2004
(2004-09-29), pages 26-29, XP055194396, DOI:
10.2118/90506-MS Retrieved from the Internet:
URL:https://www.onepetro.org/download/conf
erence-paper/SPE-90506-MS?id=conference-pa
per/SPE-90506-MS [retrieved on 2015-06-09]**

EP 2 817 734 B1

**Description**

CROSS-REFERENCE TO RELATED APPLICATIONS

This application claims priority to Provisional U.S. Application Ser. No. 61/660,678, titled "Method for Optimizing Gas Lift Injection Rates in an Integrated Reservoir and Surface Flow System" and filed June 15, 2012 by Graham Christopher Fleming and Qin Lu.

BACKGROUND

Oil field operators dedicate significant resources to improve the recovery of hydrocarbons from reservoirs while reducing recovery costs. To achieve these goals, reservoir engineers both monitor the current state of the reservoir and attempt to predict future behavior given a set of current and/or postulated conditions. Reservoir monitoring, sometimes referred to as reservoir surveillance, involves the regular collection and monitoring of measured data from within and around the wells of a reservoir. Such data may include, but is not limited to, water saturation, water and oil cuts, fluid pressure and fluid flow rates. As the data is collected, it is archived into a historical database.

The collected production data, however, mostly reflects conditions immediately around the reservoir wells. To provide a more complete picture of the state of a reservoir, simulations are executed that model the overall behavior of the entire reservoir based on the collected data, both current and historical. These simulations predict the reservoir's overall current state, producing simulated data values both near and at a distance from the wellbores. Simulated near-wellbore data can be correlated against measured near-wellbore data, and modeled parameters are adjusted as needed to reduce the error between the simulated and measured data. Once so adjusted, the simulated data, both near and at a distance from the wellbore, may be relied upon to assess the overall state of the reservoir. Such data may also be relied upon to predict the future behavior of the reservoir based upon either actual or hypothetical conditions input by an operator of the simulator. Reservoir simulations, particularly those that perform full physics numerical simulations of large reservoirs, are computationally intensive and can take hours, even days to execute.

Non-patent publication by P Wang et al, entitled "OPTIMIZATION OF PRODUCTION FROM MATURE FIELDS" (STANFORD UNIVERSITY, 17th World Petroleum Congress, XP055194471) provides a way of solving a nonlinearly constrained production optimisation problem. The problem is attempted to be solved by a heuristic nonlinear optimisation method.

Non-patent publication by Walt Dobbs et al, entitled "SPE 145070 Coupled Surface/Subsurface Simulation of an Offshore K2 Field" (SPE Reservoir Characterisation and Simulation Conference; XP055194586) discloses an evaluation of a host of development options involving artificial lift, additional wells, miscible gas injection, and water injection through an optimisation-under-uncertainty approach.

Non-patent publication by P Wang et al, entitled "Gas Lift Optimization for Long-Term Reservoir Simulations" (SPE Annual Technical Conference and Exhibition; XP055194396) relates to the gas-lift optimisation problem to maximise the daily hydrocarbon production by selecting optimally the well production and lift gas rates subject to pressure and rate constraints in nodes of the surface pipeline network and to the amount of lift gas available. The problem is attempted to be solved in selected iteration of a reservoir simulation time step.

BRIEF DESCRIPTION OF THE DRAWINGS

A better understanding of the various disclosed embodiments can be obtained when the following detailed description is considered in conjunction with the attached drawings, in which:

FIG. 1 shows an illustrative simulation process.

FIG. 2 shows an illustrative hydrocarbon production system.

FIG. 3A shows an illustrative production well that provides measured well and gas lift data.

FIG. 3B shows a simplified diagram of an illustrative gas lift environment.

FIG. 4 shows an illustrative gas lift rate management method.

FIG. 5 shows another illustrative gas lift rate management method.

FIG. 6 shows an illustrative control interface for the hydrocarbon production system of FIG. 2.

It should be understood that the drawings and corresponding detailed description do not limit the disclosure, but on the contrary, they provide the foundation for understanding all modifications, equivalents, and alternatives falling within the scope of the appended claims.

DETAILED DESCRIPTION

Disclosed herein are methods and systems for gas lift rate management of a monitored hydrocarbon production system with multiple wells, a surface network, and a facility. As described herein, the production of hydrocarbons from one or more reservoirs feeding a surface network and facility involves controlling the production of individual wells (i.e., individual well production can be throttled up or down). One way to throttle up individual well production is by applying gas lift operations to a well. Because gas lift operations are costly and their effectiveness is limited (i.e., there is a point where injecting more gas does not result in higher well production), such operations should not be applied arbitrarily to all production wells. The disclosed gas lift rate management techniques determine gas lift rates as part of an overall hydrocarbon production system solution that aligns well production with surface network and facility production limits, and that throttles well production over time as needed to maintain production at or near facility production limits.

In some embodiments, the overall hydrocarbon production system solution is determined by modeling the behavior of production system components using various parameters. More specifically, separate equations and parameters may be applied to estimate the behavior of fluids in one or more reservoirs, in individual production wells, in the surface network, and/or in the facility. Solving such equations independently or at a single moment in time yields a disjointed and therefore sub-optimal solution (i.e., the production rate and/or cost of production over time is sub-optimal). In contrast, solving such equations together (referred to herein as solving fully-coupled equations) at multiple time steps involves more iterations and processing, but yields a more optimal solution.

Hydrocarbon production systems can be modeled using many different equations and parameters. Accordingly, it should be understood that the disclosed equations and parameters are examples only and are not intended to limit embodiments to a particular equation or set of equations. The disclosed embodiments illustrate an example strategy to expedite convergence of a production system solution modeled using fully-coupled equations by fixing certain parameters and floating other parameters (the floating parameters may still be subject to range restrictions as described herein).

Hydrocarbon production simulation involves estimating or determining the material components of a reservoir and their state (phase saturations, pressure, temperature, etc.). The simulation further estimates the movement of fluids within and out of the reservoir once production wells are taken into account. The simulation also may account for various enhanced oil recovery (EOR) techniques (e.g., use of injection wells, treatments, and/or gas lift operations). Finally, the simulation may account for various constraints that limit production or EOR operations. With all of the different parameters that could be taken into account by the simulation, management decisions have to be made regarding the trade-off between simulation efficiency and accuracy. In other words, the choice to be accurate for some simulation parameters and efficient for other parameters is an important strategic decision that affects production costs and profitability.

Disclosed herein is a simulation strategy to efficiently converge the solution for a fully-coupled set of equations that model a production system. In at least some embodiments, the disclosed simulation strategy identifies the production wells and the default production level for each well needed to match production output from the wells to a facility production limit. As used herein, the default production level for a well refers to a well's maximum production level without use of EOR techniques. Alternatively, the default production level for a well may refer to a well's production level using default EOR operations such as reservoir injections, treatments, and/or gas lift injections. Over time, the default production level for one or more wells may drop as the pressure in the reservoir is affected by fluid extraction. Accordingly, default EOR options applied by the simulation strategy may correspond to low levels of available EOR operations. In this manner, the costs and complexities of EOR operations are initially small and can be raised over time. As needed (e.g., in response to a decrease in the default production level of one or more wells), the simulation solution calls for increased application of available EOR over time to maintain production from the wells at or near the facility production limit. However, if a predetermined EOR limit is reached (e.g., a gas lift capacity limit, a treatment limit, and/or a reservoir injection limit), then the simulation solution honors the EOR limit even though production from the wells may drop below the facility production limit. This disclosed strategy is intended to enable efficient convergence of a solution to a fully-coupled set of equations that model the production system. Once the solution has been determined within an acceptable tolerance, further simulations can be avoided or reduced in number since production levels can be throttled up or down as needed to match a facility production limit using swing wells and/or available EOR operations.

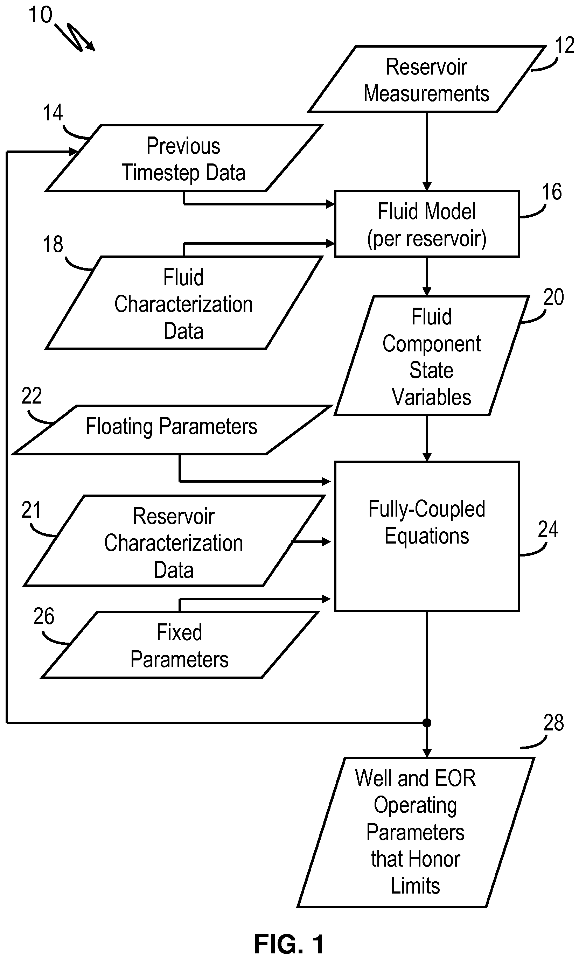

FIG. 1 shows an illustrative simulation process 10 to determine a production system solution as described herein. As shown, the simulation process 10 employs a fluid model 16 to determine fluid component state variables 20 that represent the reservoir fluids and their attributes. The inputs to the fluid model 16 may include measurements or estimates such as reservoir measurements 12, previous timestep data 14, and fluid characterization data 18. The reservoir measurements 12 may include pressure, temperature, fluid flow or other measurements collected downhole near the well perforations, along the production string, at the wellhead, and/or within the surface network (e.g., before or after fluid mixture points). Meanwhile, the previous timestep data 14 may represent updated temperatures, pressures, flow data, or other estimates output from a set of fully-coupled equations 24. Fluid characterization data 18 may include the reservoir's fluid components (e.g., heavy crude, light crude, methane, etc.) and their proportions, fluid density and viscosity for various compositions, pressures and temperatures, or other data.

Based on the above-described data input to the fluid model 16, parameters and/or parameter values are determined for each fluid component or group of components of the reservoir. The resulting parameters for each component/group are then applied to known state variables to calculate unknown state variables at each simulation point (e.g., at each "gridblock" within the reservoir, at wellbore perforations or "the sandface," and/or within the surface network). These unknown variables may include a gridblock's liquid volume fraction, solution gas-oil ratio and formation volume factor, just to name a few examples. The resulting fluid component state variables, both measured and estimated, are provided as inputs to the fully-coupled equations 24. As shown, the fully-coupled equations 24 also receive floating parameters 22, fixed parameters 26, and reservoir characterization data 21 as inputs. Examples of floating parameters 22 include EOR parameters such as gas lift injection rates. Meanwhile, examples of fixed parameters 26 include facility limits (a production capacity limit and a gas lift limit) and default production rates for individual wells. Reservoir characterization data 21 may include geological data describing a reservoir formation (e.g., log data previously collected during drilling and/or prior logging of the well) and its characteristics (e.g., porosity).

The fully-coupled equations 24 model the entire production system (reservoir(s), wells, and surface system), and account for EOR operations and facility limits as described herein. In some embodiments, Newton iterations (or other efficient convergence operations) are used to estimate the values for the floating parameters 22 used by the fully-coupled equations 24 until a production system solution within an acceptable tolerance level is achieved. The output of the solved fully-coupled equations 24 include well and EOR operating parameters 28 that honor facility and EOR limits. The simulation process 10 can be repeated for each of a plurality of different timesteps, where various parameters values determined for a given timestep are used to update the simulation for the next timestep.

In at least some embodiments, the well and EOR operating parameters 28 output from the simulation process 10 enable production output from the wells to match a facility production limit. However, if EOR limits are exceeded, the production output from the wells will decrease over time because they cannot be further enhanced. Once the solution has been determined within an acceptable tolerance, further simulations can be avoided or reduced in number since production levels can be throttled up or down as needed to match a facility production limit using swing wells and/or available EOR operations. As previously noted, the simulation process 10 can be executed for different timesteps (months or years into the future) to predict how the behavior of a hydrocarbon production system will change over time and how to manage EOR operations.

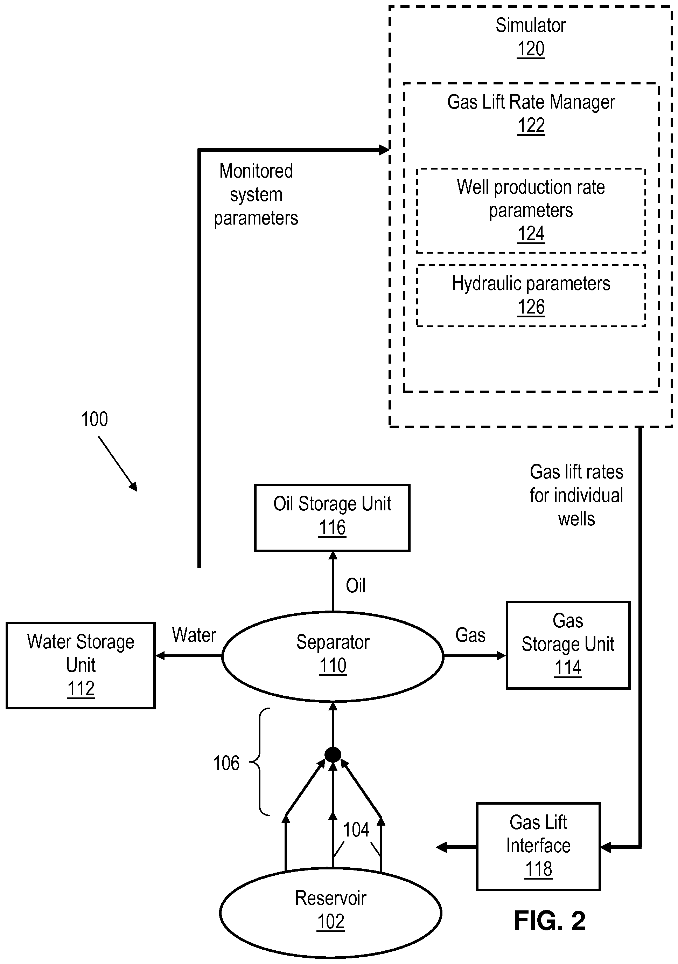

FIG. 2 shows an illustrative hydrocarbon production system 100. The illustrated hydrocarbon production system 100 includes a plurality of wells 104 extending from a reservoir 102, where the arrows representing the wells 104 show the direction of fluid flow. A surface network 106 transports fluid from the wells 104 to a separator 110, which directs water, oil, and gas to separate storage units 112, 114, and 116. The water storage unit 112 may direct collected water back to reservoir 102 or elsewhere. The gas storage unit 114 may direct collected gas back to reservoir 102, to a gas lift interface 118, or elsewhere. The oil storage unit 116 may direct collected oil to one or more refineries. In different embodiments, the separator 110 and storage units 112, 114, and 116 may be part of a single facility or part of multiple facilities associated with the hydrocarbon production system 100. Although only one oil storage unit 116 is shown, it should be understood that multiple oil storage units may be used in the hydrocarbon production system 100. Similarly, multiple water storage units and/or multiple gas storage units may be used in the hydrocarbon production system 100.

In FIG. 2, the hydrocarbon production system 100 is associated with a simulator 120 corresponding to software run by one or more computers. The simulator 120 receives monitored system parameters from various components of the hydrocarbon production system 100, and determines various control parameters for the hydrocarbon production system 100. Of particular relevance to the disclosed gas lift rate management strategy, the simulator 120 outputs gas lift rates for individual wells 104. In accordance with at least some embodiments, the simulator 120 performs the operations of the simulation process 10 discussed in FIG. 1.

As shown, the simulator 120 includes a gas lift rate manager 122 that determines the gas lift rates for individual wells based on well production rate parameters 124 and hydraulic parameters 126. In some embodiments, at least some of the well production parameters 124 and/or hydraulic parameters 126 are input into the simulator 120 as measurements or fixed value estimates. Meanwhile, others of the well production parameters 124 and/or hydraulic parameters 126 are floating parameters and are determined during the simulation as part of the production system solution. Once a solution has been determined, the simulator 120 is able to provide gas lift rates for individual wells to a gas lift interface 118 that manages gas lift operations.

In some embodiments, the disclosed gas lift rate management operations optimally allocate available lift gas to wells in order to maximize hydrocarbon production under various facility constraints. Rather than treat both gas lift rates and well production rates as decision variables, the disclosed gas lift rate management operations treat only the well production rates as decision variables, and directly calculate the required gas lift rates. More specifically, surface facility equations (e.g., well and tubing hydraulics equations) are solved with fixed reservoir conditions at the beginning of a time step, to obtain the gas lift rates for each well as a function of the well production rates. An optimizer is then used to optimize a benefit function, subject to facility constraints, with the well production rates used as decision variables. Once the optimizer has calculated the well production rates for a time step, these rates are imposed as constraints for the overall production system solution (reservoir, well, and surface network) and the gas lift rates can be adjusted. If, for example, reservoir pressure declines during the time step (or the fluid mobilities change) such that the previously determined gas lift rates are insufficient to maintain the desired well production rate, then new gas lift rates are determined.

Rather than arbitrarily adjust gas lift rates, in some embodiments, the simulator 120 determines well rate production parameters 124 (including EOR parameters) such that production output matches a facility production limit. By fixing the individual well production rates so that the facility production limits are satisfied, the simulator 120 is able to expedite convergence of a solution for suitable EOR parameters including well-specific gas lift injection rates. The fixed well production rates are associated with the following well production rate constraint equation:

$$Q_{pi}(q_{wt}, x_w, q_{gt}, x_g) = C_i, \qquad (1)$$

where $C_i$ is the well rate constraint for a particular well (well "$i$"), $Q_{pi}$ is the flow rate of the constrained phase p in a particular well, $q_{wt}$ is the total mass flow rate flowing from the reservoir into a particular well, $x_w$ is the composition of the fluid flowing into a particular well, $q_{gt}$ is the total mass flow rate of gas lift for a particular well, and $x_g$ is the composition of gas lift gas for a particular well. The composition of gas lift applied to a well may be based on gas lift measurements/characterizations.

In order for the total mass flow rate of gas lift applied to a well to be optimal, hydraulic parameters 126 should be considered. The hydraulic parameters 126 determine the difference between pressure at the bottom of a well and pressure at the top of the well. By taking this difference into account, an optimal value for the total mass flow rate of gas lift applied to a well is determined (*i.e.,* not more or less than what is needed). In some embodiments, the hydraulic parameters 126 that constrain well production are associated with a hydraulic equation of the form:

$$P_b - P_t = f(P_b, P_t, q_{wt}, x_w, q_{gt}, x_g), \qquad (2)$$

where $P_b$ is the pressure at the bottom of a particular well, and $P_t$ is the pressure at the top of the particular well. The result of using equations 1 and 2 in the system of fully-coupled equations 24 is that the production system solution determines the gas lift rates necessary to maintain the specified well production rates without using more or less gas lift gas than is necessary. In other words, well production is partly a function of gas lift rate. As the gas lift rate increases, the well production rate first increases, reaches a maximum, and then declines. Accordingly, in some embodiments, the disclosed gas lift rate management operations apply equations 1 and 2 to maintain well production rates and gas lift rates at their optimal levels.

In some embodiments, the right hand side ($C_i$) of equation 1 is fixed (the result of performing the optimization with fixed reservoir conditions). By using equations 1 and 2, the simulator calculates the independent variables $q_{wt}$, $x_w$, $q_{gt}$, $P_b$ and $P_t$. In some cases, the composition of the gas lift gas $x_g$ is known or predetermined (e.g., from another equation in the fully-coupled equations 24). Meanwhile, the total mass flow rate and composition of fluid estimates are calculated by the simulator. In contrast to other simulators that use fixed gas lift rate constraints, the disclosed technique enables calculation of gas lift rates based on well production rates (allowing gas lift rates that adjust themselves as the reservoir depletes).

As previously discussed, selected well production rates may be based on facility production limits. For example, selected well production rates may enable the total production from a set of production wells to match facility production limits. In some scenarios, facility gas lift limits may be reached while attempting to match total production from a set of production wells with facility production limits. In such case, further gas lift operations are not available and well production rates may decline over time. Even so, the gas lift rate manager 122 will provide gas lift rates that maintain total production close to facility production limits. As long as the total production cannot be improved upon by further EOR operations and/or swing wells, further simulation operations are not needed or at least the frequency of simulations can be reduced, which saves considerable time and reduces costs. If it is determined that production can be improved upon by further EOR operations and/or swing wells without violating facility production limits, additional simulations may be performed to determine new well production rates and corresponding gas lift rates. This process may continue as needed until the production system is aligned with facility limits such as production limits, water cut limits, gas collection limits, gas lift limits, and/or other limits.

The disclosed gas lift rate management operations may be combined with other production system management operations to ensure production stays near optimal levels without exceeding facility limits. With the disclosed gas lift rate management operations, the well production rates enable production to stay at or near facility production limits, even if some wells cannot produce at the rates calculated by the optimizer (e.g., due to pressure decline, changing fluid mobilities, and/or the gas lift rate reaching the point where additional gas lift does not increase production).

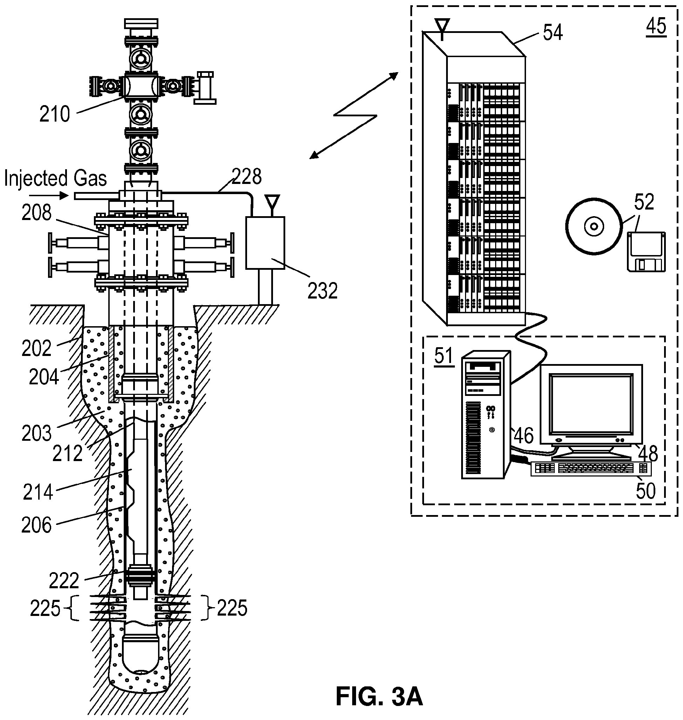

The systems and methods described herein rely in part on measured data collected from various production system components including fluid storage units, surface network components, and wells, such as those found in hydrocarbon production fields. Such fields generally include multiple producer wells that provide access to the reservoir fluids underground. Measured well data is collected regularly from each producer well to track changing conditions in the reservoir. FIG. 3A shows an example of data collection from a production well. As shown, the production well includes a borehole 202 that has been drilled into the earth. Such boreholes are routinely drilled to ten thousand feet or more in depth and can be steered horizontally for perhaps twice that distance. The production well also includes a casing header 204 and casing 206, both secured into place by cement 203. Perforations 225 may extend into the surrounding formation through cement 203 and casing 206 to facilitate fluid flow into the production well. Blowout preventer (BOP) 208 couples to casing header 204 and production wellhead 210, which together seal in the well head and enable fluids to be extracted from the well in a safe and controlled manner.

The use of measurement devices permanently installed in the well along with the gas lift system facilitates monitoring and control of gas lift operations. In some embodiments, different transducers send signals to the surface, where the signals are stored, evaluated and used to control gas lift operations. Measured well data is periodically sampled and collected from the production well and combined with measurements from other wells within a reservoir, enabling the overall state of the reservoir to be monitored and assessed. These measurements (e.g., bottom hole temperatures, pressures and flow rates) may be taken using a number of different downhole and surface instruments. Additional devices coupled in-line with production tubing 212 include gas lift mandrel 214 (to control the injected gas flow into production tubing 212) and packer 222 (to isolate the production zone below the packer from the rest of the well). Additional surface measurement devices may be used to measure, for example, the tubing head pressure and temperature and the casing head pressure.

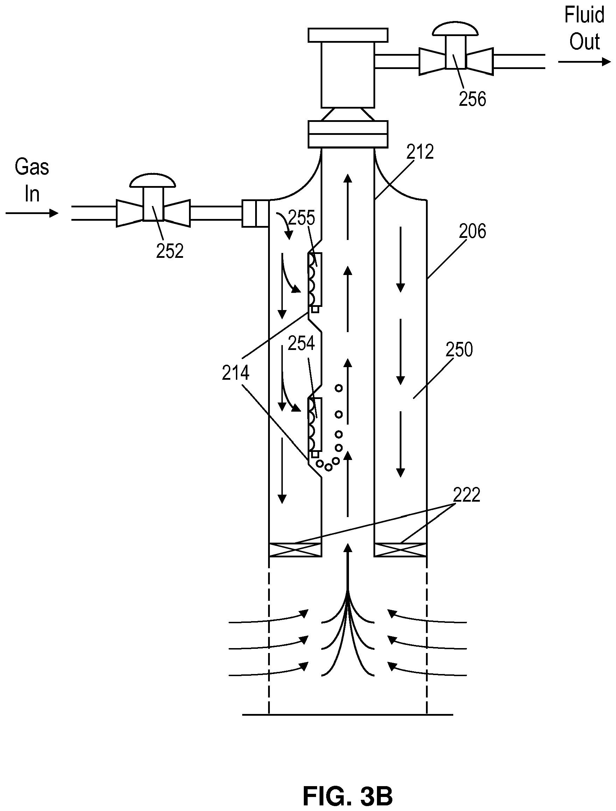

FIG. 3B shows a simplified diagram of an illustrative gas lift environment, which includes some components from FIG. 3A while excluding others for clarity. As shown, gas is injected into the annulus 250 between casing 206 and production tubing 212 via gas lift choke 252, which regulates the gas injection pressure. The pressurized gas within annulus 250, which is separated from the production zone by packer 222, passes through injection valve 254 (mounted on mandrel 214). The injected gas reduces fluid density and viscosity, thereby reducing pressure differential and facilitating fluid flow to the surface. In at least some illustrative embodiments additional valves such as valve 255 are provided to increase the gas flow during the process of unloading the well (e.g., when initiating flow within a well by removing the column of kill fluid). FIG. 3B shows the well after unloading has completed and additional valve 255 has closed. The valves allow pressurized injection gas into production tubing 212 while preventing the fluid within the tubing from flowing back out into annulus 250. Fluid that includes formation oil and injected gas flow through production tubing 212 to the surface and out production choke 256, which regulates the flow of produced fluid exiting the well.

Referring again to FIG. 3A, cable 228 provides power to various surface and downhole devices to which it couples (e.g., gas and/or fluid pressure, flow and temperature monitoring devices), as well as signal paths (electrical, optical, etc.,) for control signals from control panel 232 to the devices, and for telemetry signals received by control panel 232 from the devices. Alternatively, the devices may be powered by other sources (e.g., batteries) with control and telemetry signals being exchanged between control panel 232 and the devices wirelessly (e.g., using acoustic or radio frequency communications) or using a combination of wired and wireless communication. The devices may be controlled and monitored locally by field personnel using a user interface built into control panel 232, or may be controlled and monitored by a computer system 45. Communication between control panel 232 and computer system 45 may be via a wireless network (e.g., a cellular network), via a cabled network (e.g., a cabled connection to the Internet), or a combination of wireless and cabled networks.

In at least some illustrative embodiments, additional well data is collected using a production logging tool, which may be lowered by cable into production tubing 212. In other illustrative embodiments, production tubing 212 is first removed, and the production logging tool is then lowered into casing 206. In other alternative embodiments, an alternative technique that is sometimes used is logging with coil tubing, in which production logging tool couples to the end of coil tubing pulled from a reel and pushed downhole by a tubing injector positioned at the top of production wellhead 210. As before, the tool may be pushed down either production tubing 212 or casing 206 after production tubing 212 has been removed. Regardless of the technique used to introduce and remove it, the production logging tool provides additional data that can be used to supplement data collected from the production tubing and casing measurement devices. The production logging tool data may be communicated to computer system 45 during the logging process, or alternatively may be downloaded from the production logging tool after the tool assembly is retrieved.

In some embodiments, control panel 232 includes a remote terminal unit (RTU) which collects the data from the downhole measurement devices and forwards it to a supervisory control and data acquisition (SCADA) system that is part of computer system 45. In the illustrative embodiment shown, computer system 45 includes a set of blade servers 54 that includes several processor blades, at least some of which provide the above-described SCADA functionality. Other processor blades may be used to implement the gas lift rate management operations described herein. Computer system 45 also includes user workstation 51, which includes a general processing system 46. Both the processor blades of blade server 54 and general processing system 46 are preferably configured by software, shown in FIG. 2A in the form of removable, non-transitory (i.e., non-volatile) information storage media 52, to process collected production system data. The software may also include downloadable software accessed through a network (e.g., via the Internet). General processing system 46 couples to a display device 48 and a user-input device 50 to enable a human operator to interact with the system software 52. Alternatively, display device 48 and user-input device 50 may couple to a processing blade within blade server 54 that operates as general processing system 46 of user workstation 51.

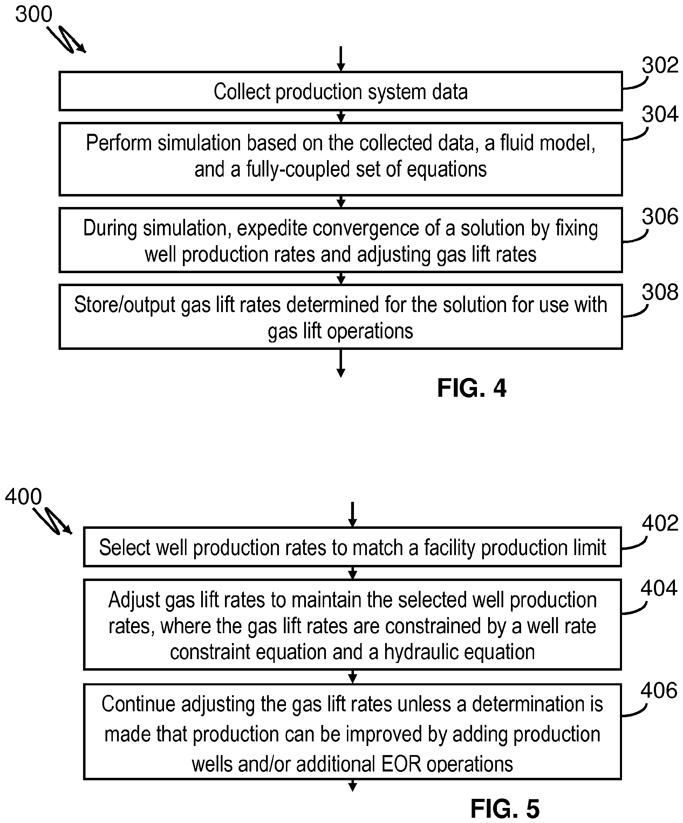

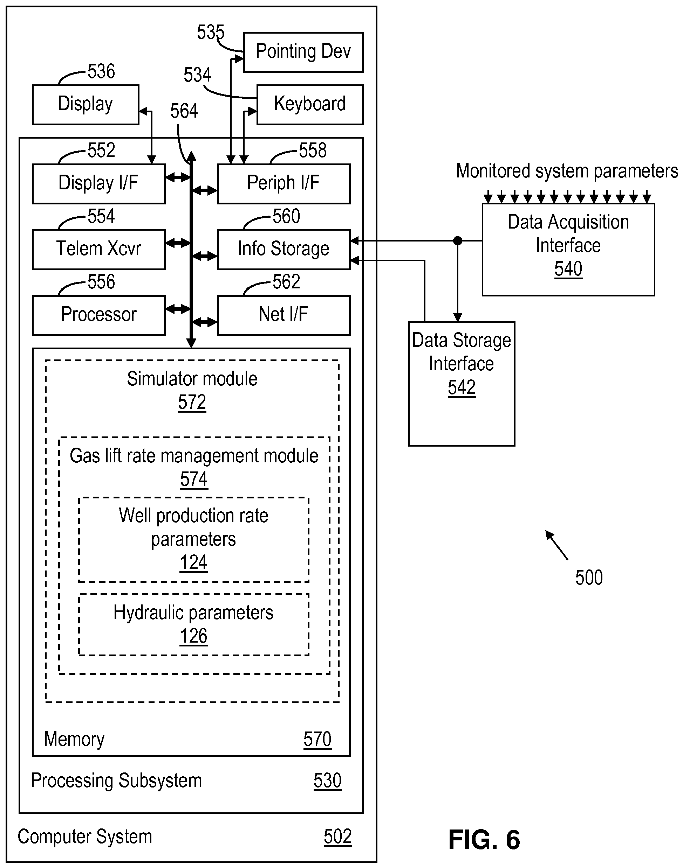

FIG. 4 shows an illustrative gas lift rate management method 300. The method 300 may be performed, for example, by hardware and software components of computer system 45 or 502 (see FIGS. 3A and 6). The method 300 includes collecting production system data at block 302. Examples of production system data include reservoir data, well data, surface network data, and/or facility data. At block 304, a simulation is performed based on the collected data, a fluid model, and a fully-coupled set of equations. In at least some embodiments, the simulation at block 304 corresponds to the simulation process 10 described in FIG. 1 and/or the operations of simulator 120 described for FIG. 2. The simulation estimates the behavior of the production system at a particular time or during a time range while applying various constraints. At block 306, convergence of a solution is expedited during simulation by fixing well production rates and adjusting gas lift rates as described herein. For example, in at least some embodiments, the step of block 304 involves applying equations 1 and 2 discussed previously to determine gas lift rates as part of an overall production system solution constrained by facility production limits, facility gas lift limits, and/or other limits. At block 308, gas lift rates for individual wells determined at block 306 are stored and/or output for use with gas lift operations.

FIG. 5 shows another illustrative gas lift rate management method 400. The method 400 may be performed, for example, by hardware and software components of computer system 45 or 502 (see FIGS. 3A and 5). The method 400 includes selecting well production rates to match a facility production limit at block 402. At block 404, gas lift rates are adjusted to maintain the selected well production rates, where the gas lift rates are constrained by a well rate constraint equation and a hydraulic equation as described herein. At block 406, gas lift rates continue to be adjusted unless a determination is made that production can be improved by adding production wells and/or EOR operations. In the scenario that production can be improved, the facility production limits are not being met by the current set of production wells and EOR operations. In such case, new production wells and/or EOR operations may be implemented in the production system and the method 400 would be performed again to determine appropriate gas lift rates. Of course, it may alternatively be determined that new production wells and/or EOR operations are not worth the additional cost to maximize facility production limits.

FIG. 6 shows an illustrative control interface 500 suitable for a hydrocarbon production system such as system 100 of FIG. 2. The illustrated control interface 500 includes a computer system 502 coupled to a data acquisition interface 540 and a data storage interface 542. The computer system 502, data storage interface 542, and data acquisition interface 540 may correspond to components of computer system 45 and/or control panel 232 of FIG. 3B. In at least some embodiments, a user is able to interact with computer system 502 via keyboard 534 and pointing device 535 (e.g., a mouse) to send commands and configuration data to one or more components of a production system.

As shown, the computer system 502 includes a processing subsystem 530 with a display interface 552, a telemetry transceiver 554, a processor 556, a peripheral interface 558, an information storage device 560, a network interface 562 and a memory 570. Bus 564 couples each of these elements to each other and transports their communications. In some embodiments, telemetry transceiver 554 enables the processing subsystem 530 to communicate with downhole and/or surface devices (either directly or indirectly), and network interface 562 enables communications with other systems (e.g., a central data processing facility via the Internet). In accordance with embodiments, user input received via pointing device 535, keyboard 534, and/or peripheral interface 558 are utilized by processor 556 to perform gas lift rate management operations as described herein. Further, instructions/data from memory 570, information storage device 560, and/or data storage interface 542 are utilized by processor 556 to perform gas lift rate management operations as described herein.

As shown, the memory 570 comprises a simulator module 572 that includes gas lift rate management module 574. In alternative embodiments, the gas lift rate management module 574 and simulator module 572 are separate modules in communication with each other. The simulator module 572 and gas lift rate management module 574 are software modules that, when executed, cause a processor to perform the operations described for the simulation process 10 of FIG. 1 and simulator 120 of FIG. 2. As shown, the gas lift rate management module 574 may determine gas lift rates based on well production rate parameters 124, hydraulic parameters 126, and facility limits as described previously. Examples of facility limits include facility production rate limits, facility gas rate limits, water cut limits, and/or other limits. Once gas lift rates have been determined by the gas lift rate management module 574, the computer system 502 stores the values and/or provides the gas lift rates to production system components (e.g., gas lift interface 118 of FIG. 2) that control the application of gas lift to individual wells.

In some embodiments, the determined gas lift rates and related information may be displayed to a production system operator for review. Alternatively, the determined gas lift rates may be used to automatically control gas lift operations of a production system. In some embodiments, the disclosed gas lift rate management operations are used to plan out or adapt a new production system before production begins. Alternatively, the disclosed gas lift rate management operations are used to optimize operations of a production system that is already producing.

Numerous other modifications, equivalents, and alternatives, will become apparent to those skilled in the art once the above disclosure is fully appreciated. For example, although at least some software embodiments have been described as including modules performing specific functions, other embodiments may include software modules that combine the functions of the modules described herein. Also, it is anticipated that as computer system performance increases, it may be possible in the future to implement the above-described software-based embodiments using much smaller hardware, making it possible to perform the described gas lift rate management operations using on-site systems (e.g., systems operated within a well-logging truck located at the reservoir). Additionally, although at least some elements of the embodiments of the present disclosure are described within the context of monitoring real-time data, systems that use previously recorded data (e.g., "data playback" systems) and/or simulated data (e.g., training simulators) are also within the scope of the disclosure. It is intended that the following claims be interpreted to embrace all such modifications, equivalents, and alternatives where applicable.

**Claims**

1. A method for gas lift rate management, comprising:

   collecting (302) production system data;
   performing (304) a simulation based on the collected data, a fluid model, and a fully-coupled set of equations;
   expediting (306) convergence of a solution for the simulation by fixing well production rates and adjusting gas lift rates; and
   storing (308) the gas lift rates determined for the solution for use with gas lift operations of the production system, wherein the selected well production rates match a facility production limit, and wherein the gas lift rates are limited by the facility gas lift limit
   wherein each of the selected well production rates is based on a well production rate constraint equation:

   $$Q_{pi}\left(q_{wt},\ x_w,\ q_{gt},\ x_g\right) = C_i,$$

   where $C_i$ is the well rate constraint for well $i$, $Q_{pi}$ is the flow rate of constrained phase p in well $i$, $q_{wt}$ is the total mass flow rate flowing from the reservoir into well $i$, $x_w$ is the composition of fluid flowing into well $i$, $q_{gt}$ is the total mass flow rate of gas lift for well $i$, and $x_g$ is the composition of gas lift gas for well $i$,
   wherein performing the simulation comprises selecting a value for $C_i$ using fixed reservoir conditions, selecting a predetermined value for $x_g$, and solving for $q_{wt}$, $x_w$, and $q_{gt}$.

2. The method of claim 1, further comprising:

   determining a difference between pressure at a bottom of the well and pressure at a top of the well; and
   using the difference to optimize the gas lift rates determined for the solution.

3. The method according to any one of claims 1 to 2, performing at least one iteration of a production system simulation in response to determining that the solution is sub-optimal, and selecting new well production rates based on the at least one iteration.

4. The method of claim 1, wherein said selecting and said adjusting are based on a well rate constraint equation, a hydraulic equation, facility production limits, and facility gas lift limits.

5. A gas lift rate management system, comprising:

   a memory (570) having a gas lift rate management module (574); and
   one or more processors (556) coupled to the memory, wherein the gas lift rate management module, when executed, cause the one or more processors to:

perform a production system simulation based on a fluid model and a fully-coupled set of equations;
expedite convergence of a solution for the production system simulation by fixing well production rates and adjusting gas lift rates; and
store the gas lift rates determined for the solution for use with gas lift operations of the production system, wherein the selected well production rates match a facility production limit, and wherein the gas lift rates are limited by the facility gas lift limit
further comprising a data acquisition interface that collects well data, surface network data, and facility data, wherein at least some of the collected data is used to select the well production rates
wherein the simulation selects the well production rates based on a well production rate constraint equation:

$$Q_{pi}\,(q_{wt},\,x_w,\,q_{gt},\,x_g) = C_i\,,$$

where $C_i$ is the well rate constraint for well $i$, $Q_{pi}$ is the flow rate of constrained phase p in well $i$, $q_{wt}$ is the total mass flow rate flowing from the reservoir into well $i$, $x_w$ is the composition of fluid flowing into well $i$, $q_{gt}$ is the total mass flow rate of gas lift for well $i$, and $x_g$ is the composition of gas lift gas for well $i$ and wherein the simulation selects a value for $C_i$ using fixed reservoir conditions, selects a predetermined value for $x_g$, and solves for $q_{wt}$, $x_w$, and $q_{gt}$.

6.  The gas lift rate management system of claim 5, wherein the gas lift rate management module, when executed, causes the one or more processors to:

    determine a difference between pressure at a bottom of the well and pressure at a top of the well; and
    use the difference to optimize the gas lift rates determined for the solution.

7.  The gas lift rate management system of claim 5, further comprising a gas lift control interface that performs gas lift operations based on the stored gas lift rates.

8.  The gas lift rate management system according to any one of claims 5 to 7, wherein the gas lift rate management module, when executed, enables calculation of gas lift rates based on well production rates, wherein the gas lift rates adjust themselves as a reservoir depletes.

9.  The gas lift rate management system according to any one of claims 5 to 7, wherein the gas lift rate management module, when executed, causes the one or more processors to perform at least one iteration of a production system simulation in response to determining that the solution is sub-optimal, and to select new well production rates based on the simulation.

10. The gas lift rate management system according to claim 5, wherein the gas lift rate management module, when executed, causes the one or more processors to select the well production rates and to adjust the gas lift rates based on a well rate constraint equation, a hydraulic equation, facility production limits, and facility gas lift limits.

11. A non-transitory computer-readable medium that stores gas lift rate management software, wherein the software, when executed, causes a computer to:

    perform a production system simulation based on a fluid model and a fully-coupled set of equations;
    expedite convergence of a solution for the production system simulation by selecting well production rates and adjusting gas lift rates; and
    store the gas lift rates determined for the solution for use with gas lift operations of the production system, wherein the selected well production rates are constrained by a facility production limit, and wherein the gas lift rates are limited by the facility gas lift limit
    wherein each of the selected well production rates is based on a well production rate constraint equation:

$$Q_{pi}\,(q_{wt},\,x_w,\,q_{gt},\,x_g) = C_i\,,$$

where $C_i$ is the well rate constraint for well $i$, $Q_{pi}$ is the flow rate of constrained phase p in well $i$, $q_{wt}$ is the total mass flow rate flowing from the reservoir into well $i$, $x_w$ is the composition of fluid flowing into well $i$, $q_{gt}$ is the total mass flow rate of gas lift for well $i$, and $x_g$ is the composition of gas lift gas for well $i$, wherein performing the simulation comprises selecting a value for $C_i$ using fixed reservoir conditions, selecting a predetermined value for $x_g$, and solving for $q_{wt}$, $x_w$, and $q_{gt}$.

12. The non-transitory computer-readable medium of claim 11, wherein the software, when executed, further causes the computer to:

determine a difference between pressure at a bottom of the well and pressure at a top of the well; and
use the difference to optimize the gas lift rates determined for the solution,
wherein the selected well production rates and the adjusted gas lift rates are constrained by a well rate constraint equation, a hydraulic equation, facility production limits, and the facility gas lift limits.

## Patentansprüche

1. Verfahren zur Gasförderungsratenverwaltung, das Folgendes umfasst:

Sammeln (302) von Produktionssystemdaten;
Durchführen (304) einer Simulation auf Grundlage der gesammelten Daten, eines Fluidmodells und eines vollständig gekoppelten Satzes von Gleichungen;
Beschleunigen (306) der Konvergenz einer Lösung für die Simulation durch Festlegen der Bohrungsproduktionsraten und Einstellen der Gasförderungsraten; und
Speichern (308) der Gasförderungsraten, die für die Lösung zur Verwendung mit Gasförderungsvorgängen des Produktionssystems bestimmt wurden,
wobei die ausgewählten Bohrungsproduktionsraten einer Anlagenproduktionsgrenze entsprechen, und wobei die Gasförderungsraten durch die Anlagengasförderungsgrenze beschränkt sind,
wobei jede der ausgewählten Bohrungsproduktionsraten auf einer Bohrungsproduktionsraten-Abhängigkeitsgleichung beruht:

$$Q_{pi}(q_{wt},\ x_w,\ q_{gt},\ x_g)\ =\ C_i,$$

wobei $C_i$ die Bohrungsratenabhängigkeit für Bohrung $i$ ist, $Q_{pi}$ die Strömungsrate von Abhängigkeitsphase p in Bohrung $i$ ist, $q_{wt}$ die gesamte Massenströmungsrate, die von dem Behälter in die Bohrung $i$ strömt, ist, $x_w$ die Zusammensetzung von Fluid, das in die Bohrung $i$ strömt, ist, $q_{gt}$ die gesamte Massenströmungsrate von Gasförderung für Bohrung $i$ ist, und $x_g$ die Zusammensetzung von Gasförderungsgas für die Bohrung $i$ ist, wobei Durchführen der Simulation das Auswählen eines Werts für $C_i$ unter Verwendung von festgelegten Behälterbedingungen, Auswählen eines vorbestimmten Werts für $x_g$ und Lösen nach $q_{wt}$, $x_w$, und $q_{gt}$ umfasst.

2. Verfahren nach Anspruch 1, das ferner Folgendes umfasst:

Bestimmen eines Unterschieds zwischen Druck an einem Boden der Bohrung und Druck an einem oberen Teil der Bohrung; und
Verwenden des Unterschieds, um die Gasförderungsraten, die für die Lösung bestimmt wurden, zu optimieren.

3. Verfahren nach einem der Ansprüche 1 bis 2, wobei mindestens eine Wiederholung einer Produktionssystemsimulation als Reaktion auf Bestimmen, dass die Lösung suboptimal ist, durchgeführt wird und neue Bohrungsproduktionsraten auf Grundlage der mindestens einen Wiederholung ausgewählt werden.

4. Verfahren nach Anspruch 1, wobei das Auswählen und Einstellen auf einer Bohrungsratenabhängigkeitsgleichung, einer Hydraulikgleichung, Anlagenproduktionsgrenzen und Anlagengasförderungsgrenzen beruhen.

5. Gasförderungsratenverwaltungssystem, das Folgendes umfasst:

einen Speicher (570), der ein Gasförderungsratenverwaltungsmodul (574) aufweist; und

einen oder mehrere Prozessoren (556), die an den Speicher gekoppelt sind, wobei das Gasförderungsratenverwaltungsmodul, wenn es ausgeführt wird, den einen oder die mehreren Prozessoren zu Folgendem veranlasst:

Durchführen einer Produktionssystemsimulation auf Grundlage eines Fluidmodells und eines vollständig gekoppelten Satzes von Gleichungen;

Beschleunigen von Konvergenz einer Lösung für die Produktionssystemsimulation durch Festlegen von Bohrungsproduktionsraten und Einstellen von Gasförderungsraten; und

Speichern der Gasförderungsraten, die für die Lösung bestimmt sind, zur Verwendung mit Gasförderungsvorgängen des Produktionssystems,

wobei die ausgewählten Bohrungsproduktionsraten einer Anlagenproduktionsgrenze entsprechen, und wobei die Gasförderungsraten durch die Anlagengasförderungsgrenze beschränkt sind;

ferner umfassend eine Datenerfassungsschnittstelle, die Bohrungsdaten, Oberflächennetzwerkdaten und Anlagendaten umfasst, wobei mindestens einige der gesammelten Daten verwendet werden, um die Bohrungsproduktionsraten auszuwählen;

wobei die Simulation die Bohrungsproduktionsraten auf Grundlage einer Bohrungsproduktionsraten-Abhängigkeitsgleichung auswählt:

$$Q_{pi}(q_{wt},\ x_w,\ q_{gt},\ x_g)\ =\ C_i,$$

wobei $C_i$ die Bohrungsratenabhängigkeit für Bohrung $i$ ist, $Q_{pi}$ die Strömungsrate von Abhängigkeitsphase p in Bohrung $i$ ist, $q_{wt}$ die gesamte Massenströmungsrate, die von dem Behälter in die Bohrung $i$ strömt, ist, $x_w$ die Zusammensetzung von Fluid, das in die Bohrung $i$ strömt, ist, $q_{gt}$ die gesamte Massenströmungsrate von Gasförderung für Bohrung $i$ ist, und $x_g$ die Zusammensetzung von Gasförderungsgas für die Bohrung $i$ ist, und

wobei die Simulation einen Wert für $C_i$ unter Verwendung von festgelegten Behälterbedingungen auswählt, einen vorbestimmten Wert für $x_g$ auswählt und nach $q_{wt}$, $x_w$ und $q_{gt}$ löst.

6. Gasförderungsratenverwaltungssystem nach Anspruch 5, wobei das Gasförderungsratenverwaltungsmodul, wenn es ausgeführt wird, den einen oder die mehreren Prozessoren zu Folgendem veranlasst:

Bestimmen eines Unterschieds zwischen Druck an einem Boden der Bohrung und Druck an einem oberen Teil der Bohrung; und

Verwenden des Unterschieds, um die Gasförderungsraten, die für die Lösung bestimmt wurden, zu optimieren.

7. Gasförderungsratenverwaltungssystem nach Anspruch 5, das ferner eine Gasförderungssteuerschnittstelle umfasst, die Gasförderungsvorgänge auf Grundlage von gespeicherten Gasförderungsraten ausführt.

8. Gasförderungsratenverwaltungssystem nach einem der Ansprüche 5 bis 7, wobei das Gasförderungsratenverwaltungsmodul, wenn es ausgeführt wird, Berechnen von Gasförderungsraten auf Grundlage von Bohrungsproduktionsraten ermöglicht, wobei sich die Gasförderungsraten selber einstellen, wenn sich ein Behälter leert.

9. Gasförderungsratenverwaltungssystem nach einem der Ansprüche 5 bis 7, wobei das Gasförderungsratenverwaltungsmodul, wenn es ausgeführt wird, den einen oder die mehreren Prozessoren dazu veranlasst, mindestens eine Wiederholung von einer Produktionssystemsimulation als Reaktion auf Bestimmen, dass die Lösung suboptimal ist, durchzuführen, und neue Bohrungsproduktionsraten auf Grundlage der Simulation auszuwählen.

10. Gasförderungsratenverwaltungssystem nach Anspruch 5, wobei das Gasförderungsratenverwaltungsmodul, wenn es ausgeführt wird, den einen oder die mehreren Prozessoren dazu veranlasst, die Bohrungsproduktionsraten auszuwählen und die Gasförderungsraten auf Grundlage einer BohrungsratenAbhängigkeitsgleichung, einer Hydraulikgleichung, Anlagenproduktionsgrenzen und Anlagengasförderungsgrenzen einzustellen.

11. Nichtflüchtiges computerlesbares Medium, das Gasförderungsratenverwaltungssoftware speichert, wobei die Software, wenn sie ausgeführt wird, einen Computer zu Folgendem veranlasst:

Durchführen einer Produktionssystemsimulation auf Grundlage eines Fluidmodells und eines vollständig gekoppelten Satzes von Gleichungen;

Beschleunigen der Konvergenz einer Lösung für die Produktionssystemsimulation durch Auswählen von Bohrungsproduktionsraten und Einstellen von Gasförderungsraten; und

Speichern der Gasförderungsraten, die für die Lösung bestimmt wurden, zur Verwendung mit Gasförderungsvorgängen des Produktionssystems,

wobei die ausgewählten Bohrungsproduktionsraten durch eine Anlagenproduktionsgrenze eingeschränkt sind, und wobei die Gasförderungsraten durch die Anlagengasförderungsgrenzen beschränkt sind,

wobei jede der ausgewählten Bohrungsproduktionsraten auf einer Bohrungsproduktionsraten-Abhängigkeitsgleichung beruht:

$$Q_{pi}(q_{wt},\ x_w,\ q_{gt},\ x_g)\ =\ C_i,$$

wobei $C_i$ die Bohrungsratenabhängigkeit für Bohrung $i$ ist, $Q_{pi}$ die Strömungsrate von Abhängigkeitsphase p in Bohrung $i$ ist, $q_{wt}$ die gesamte Massenströmungsrate, die von dem Behälter in die Bohrung $i$ strömt, ist, $x_w$ die Zusammensetzung von Fluid, das in die Bohrung $i$ strömt, ist, $q_{gt}$ die gesamte Massenströmungsrate von Gasförderung für Bohrung $i$ ist, und $x_g$ die Zusammensetzung von Gasförderungsgas für die Bohrung $i$ ist, wobei Durchführen der Simulation Auswählen eines Werts für $C_i$ unter Verwendung von festgelegten Behälterbedingungen, Auswählen eines vorbestimmten Werts für $x_g$ und Lösen nach $q_{wt}$, $x_w$ und $q_{gt}$ umfasst.

12. Nichtflüchtiges computerlesbares Medium nach Anspruch 11, wobei die Software, wenn sie ausgeführt wird, ferner den Computer zu Folgendem veranlasst:

Bestimmen eines Unterschieds zwischen Druck an einem Boden der Bohrung und Druck an einem oberen Teil der Bohrung; und

Verwendung des Unterschieds, um die Gasförderungsraten, die für die Lösung bestimmt wurden, zu optimieren wobei die ausgewählten Bohrungsproduktionsraten und die angepassten Gasförderungsraten durch eine BohrungsratenAbhängigkeitsgleichung, eine Hydraulikgleichung, Anlagenproduktionsgrenzen und die Anlagengasförderungsgrenzen beschränkt sind.


**Revendications**

1. Procédé de gestion de vitesse d'extraction au gaz, comprenant :

la collecte (302) de données de système de production ;

la réalisation (304) d'une simulation sur la base des données collectées, d'un modèle fluide et d'un ensemble entièrement couplé d'équations ;

l'accélération (306) de la convergence d'une solution pour la simulation par fixation de vitesses de production d'un puits et réglage de vitesses d'extraction au gaz ; et

l'enregistrement (308) des vitesses d'extraction au gaz déterminées pour la solution pour utilisation avec des opérations d'extraction au gaz du système de production,

dans lequel les vitesses de production du puits sélectionnées correspondent à une limite de production d'une installation, et dans lequel les vitesses d'extraction au gaz sont limitées par la limite d'extraction au gaz de l'installation

dans lequel chacune des vitesses de production du puits sélectionnées est basée sur une équation de contrainte de vitesse de production du puits :

$$Q_{pi}(q_{wt},\ x_w,\ q_{gt},\ x_g) = C_i,$$

où $C_i$ est la contrainte de vitesse pour le puits $i$, $Q_{pi}$ est le débit de la phase contrainte p dans le puits $i$, $q_{wt}$ est le débit massique total entre le réservoir et le puits $i$, $x_w$ est la composition du fluide s'écoulant dans le puits $i$, $q_{gt}$ est le débit massique total d'extraction au gaz pour le puits $i$, et $x_g$ est la composition du gaz extrait au gaz pour le puits $i$,

dans lequel la réalisation de la simulation comprend la sélection d'une valeur pour $C_i$ en utilisant des conditions de réservoir fixes, la sélection d'une valeur prédéterminée pour $x_g$, et la résolution pour $q_{wt}$, $x_w$, et $q_{gt}$.

**2.** Procédé selon la revendication 1, comprenant en outre :

la détermination d'une différence entre la pression au fond du puits et la pression au sommet du puits ; et
l'utilisation de la différence pour optimiser les vitesses d'extraction au gaz déterminées pour la solution.

**3.** Procédé selon l'une quelconque des revendications 1 et 2, réalisant au moins une itération d'une simulation de système de production en réponse à la détermination selon laquelle la solution est sous-optimale, et sélectionnant de nouvelles vitesses de production du puits sur la base de l'au moins une itération.

**4.** Procédé selon la revendication 1, dans lequel ladite sélection et ledit réglage sont basés sur une équation de contrainte de vitesse de puits, une équation hydraulique, des limites de production de l'installation, et des limites d'extraction au gaz de l'installation.

**5.** Système de gestion de vitesse d'extraction au gaz, comprenant :

une mémoire (570) comportant un module de gestion de vitesse d'extraction au gaz (574) ; et
un ou plusieurs processeurs (556) couplés à la mémoire, dans lequel le module de gestion de vitesse d'extraction au gaz, lorsqu'il est exécuté, amène le ou les processeurs à :
effectuer une simulation de système de production en fonction d'un modèle de fluide et d'un ensemble entièrement couplé d'équations ;
accélérer la convergence d'une solution pour la simulation du système de production par fixation de vitesses de production du puits et réglage des vitesses d'extraction au gaz ; et
enregistrer les vitesses d'extraction au gaz déterminées pour la solution pour l'utilisation avec des opérations d'extraction au gaz du système de production,
dans lequel les vitesses de production du puits sélectionnées correspondent à une limite de production d'une installation, et dans lequel les vitesses d'extraction au gaz sont limitées par la limite d'extraction au gaz de l'installation
comprenant en outre une interface d'acquisition de données qui collecte des données sur le puits, des données sur le réseau de surface et des données sur l'installation, au moins certaines des données collectées étant utilisées pour sélectionner les vitesses de production du puits
dans lequel la simulation sélectionne les vitesses de production du puits sur la base d'une équation de contrainte de vitesse de production du puits :

$$Q_{pi}\,(q_{wt},\ x_w,\ q_{gt},\ x_g) = C_i,$$

où $C_i$ est la contrainte de vitesse pour le puits $i$, $Q_{pi}$ est le débit de la phase contrainte p dans le puits $i$, $q_{wt}$ est le débit massique total entre le réservoir et le puits $i$, $x_w$ est la composition du fluide s'écoulant dans le puits $i$, $q_{gt}$ est le débit massique total d'extraction au gaz pour le puits $i$, et $x_g$ est la composition du gaz extrait au gaz pour le puits $i$, et
dans lequel la simulation sélectionne une valeur pour $C_i$ en utilisant des conditions de réservoir fixes, sélectionne une valeur prédéterminée pour $x_g$, et résout $q_{wt}$, $x_w$, et $q_{gt}$.

**6.** Système de gestion de vitesse d'extraction au gaz selon la revendication 5, dans lequel le module de gestion de vitesse d'extraction au gaz, lorsqu'il est exécuté, amène le ou les processeurs à :

déterminer une différence entre la pression au fond du puits et la pression au sommet du puits ; et
utiliser la différence pour optimiser les vitesses d'extraction au gaz déterminées pour la solution.

**7.** Système de gestion de vitesse d'extraction aux gaz selon la revendication 5, comprenant en outre une interface de commande de l'extraction au gaz qui réalise des opérations d'extraction au gaz sur la base des vitesses d'extraction au gaz enregistrées.

**8.** Système de gestion de vitesse d'extraction au gaz selon l'une quelconque des revendications 5 à 7, dans lequel le module de gestion de vitesse d'extraction au gaz, lorsqu'il est exécuté, permet le calcul de vitesses d'extraction au gaz sur la base de vitesses de production du puits, dans lequel les vitesses d'extraction au gaz se règlent automatiquement au fur et à mesure que le réservoir s'épuise.

**9.** Système de gestion de vitesse d'extraction au gaz selon l'une quelconque des revendications 5 à 7, dans lequel le module de gestion de vitesse d'extraction au gaz, lorsqu'il est exécuté, amène le ou les processeurs à réaliser au moins une itération d'une simulation de système de production en réponse à la détermination selon laquelle la solution est sous-optimale, et à sélectionner de nouvelles vitesses de production du puits sur la base de la simulation.

**10.** Système de gestion de vitesse d'extraction au gaz selon la revendication 5, dans lequel le module de gestion de vitesse d'extraction au gaz, lorsqu'il est exécuté, amène le ou les processeurs à sélectionner les vitesses de production du puits et à régler les vitesses d'extraction au gaz sur la base d'une équation de contrainte de vitesse du puits, une équation hydraulique, des limites de production de l'installation, et des limites d'extraction au gaz de l'installation.

**11.** Support non transitoire lisible par ordinateur qui enregistre un logiciel de gestion de vitesse d'extraction au gaz, dans lequel le logiciel, lorsqu'il est exécuté, amène un ordinateur à :

   effectuer une simulation de système de production en fonction d'un modèle de fluide et d'un ensemble entièrement couplé d'équations ;
   accélérer la convergence d'une solution pour la simulation du système de production par sélection de vitesses de production du puits et réglage des vitesses d'extraction au gaz ; et
   enregistrer les vitesses d'extraction au gaz déterminées pour la solution pour l'utilisation avec des opérations d'extraction au gaz du système de production,
   dans lequel les vitesses de production du puits sélectionnées sont limitées par une limite de production de l'installation, et dans lequel les vitesses d'extraction au gaz sont limitées par la limite d'extraction au gaz de l'installation
   dans lequel chacune des vitesses de production du puits sélectionnées est basée sur une équation de contrainte de vitesse de production du puits :

$$Q_{pi}\left(q_{wt},\ x_w,\ q_{gt},\ x_g\right) = C_i,$$

   où $C_i$ est la contrainte de vitesse pour le puits $i$, $Q_{pi}$ est le débit de la phase contrainte p dans le puits $i$, $q_{wt}$ est le débit massique total entre le réservoir et le puits $i$, $x_w$ est la composition du fluide s'écoulant dans le puits $i$, $q_{gt}$ est le débit massique total d'extraction au gaz pour le puits $i$, et $x_g$ est la composition du gaz extrait au gaz pour le puits $i$,
   dans lequel la réalisation de la simulation comprend la sélection d'une valeur pour $C_i$ en utilisant des conditions de réservoir fixes, la sélection d'une valeur prédéterminée pour $x_g$, et la résolution pour $q_{wt}$, $x_w$, et $q_{gt}$.

**12.** Support non transitoire lisible par ordinateur selon la revendication 11, dans lequel le logiciel, lorsqu'il est exécuté, amène en outre l'ordinateur à :

   déterminer une différence entre la pression au fond du puits et la pression au sommet du puits ; et
   utiliser la différence pour optimiser les vitesses d'extraction au gaz déterminées pour la solution,
   dans lequel les vitesses de production du puits sélectionnées et les vitesses d'extraction au gaz réglées sont limitées par une équation de contrainte de vitesse du puits, une équation hydraulique, des limites de production de l'installation, et des limites d'extraction au gaz de l'installation.

**FIG. 1**

FIG. 2

**FIG. 3A**

**FIG. 3B**

300

| Collect production system data | 302 |

| Perform simulation based on the collected data, a fluid model, and a fully-coupled set of equations | 304 |

| During simulation, expedite convergence of a solution by fixing well production rates and adjusting gas lift rates | 306 |

| Store/output gas lift rates determined for the solution for use with gas lift operations | 308 |

**FIG. 4**

400

| Select well production rates to match a facility production limit | 402 |

| Adjust gas lift rates to maintain the selected well production rates, where the gas lift rates are constrained by a well rate constraint equation and a hydraulic equation | 404 |

| Continue adjusting the gas lift rates unless a determination is made that production can be improved by adding production wells and/or additional EOR operations | 406 |

**FIG. 5**

535

Pointing Dev

534

536

Display

564

Keyboard

552

Display I/F

558

Periph I/F

554

Telem Xcvr

560

Info Storage

556

Processor

562

Net I/F

Monitored system parameters

↓↓↓↓↓↓↓↓↓↓↓↓↓

Data Acquisition
Interface
540

Data Storage
Interface
542

Simulator module
572

Gas lift rate management module
574

Well production rate
parameters
124

Hydraulic parameters
126

Memory                                    570

Processing Subsystem                      530

Computer System                           502

500

**FIG. 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61660678 B

**Non-patent literature cited in the description**

- **P WANG et al.** OPTIMIZATION OF PRODUCTION FROM MATURE FIELDS. STANFORD UNIVERSITY
- **WALT DOBBS et al.** SPE 145070 Coupled Surface/Subsurface Simulation of an Offshore K2 Field. *SPE Reservoir Characterisation and Simulation Conference*
- **P WANG et al.** Gas Lift Optimization for Long-Term Reservoir Simulations. *SPE Annual Technical Conference and Exhibition*